# EUROPEAN PATENT APPLICATION

(11) **EP 4 818 852 A1**
(43) Date of publication of application: **07.10.2026**
(21) Application number: 26170338.3
(22) Date of filing: 01.04.2026
(51) Int. Cl.: G06F 1/30, G06F 1/20

(54) **RUNTIME ANALYSIS AND BALANCED SHUTDOWN FOR LIQUID COOLING SYSTEM**

(30) Priority: 01.04.2025 US 202563781750 P; 30.03.2026 US 202619633353
(71) Applicant: Vertiv Corporation, Westerville, OH 43082 (US)
(72) Inventor: KELLER, Matthew Griffith, Westerville, 43082 (US); KUETH, Peter M, Westerville, 43082 (US)
(74) Representative: Bryn-Jacobsen, Caelia

(57) **Abstract**

A system and method for runtime analysis and shutdown control of a liquid cooling system provides coolant distribution units (CDU) for circulating a liquid coolant through downstream information technology (IT) devices via a fluid network. The downstream IT devices are powered by a primary power source via power distribution units (PDU), and the CDUs via uninterruptible power supplies (UPS: e.g., server-based, rack-based). A controller monitors battery runtimes of the UPS and, when a loss of primary power is detected, calculates a remaining system runtime based on the battery runtimes. When the system runtime is at least a minimum threshold, a shutdown protocol is initiated providing for a graceful shutdown of downstream IT devices to preserve the hardware and any active IT workloads. When the shutdown protocol is verified complete, the controller transitions the CDUs to an idle runstate until primary power is restored.

## Description

### CROSS-REFERENCE TO RELATED APPLICATIONS

The present application claims the benefit under 35 U.S.C. § 119(e) of U.S. Provisional Patent Application Serial Number 63/781,750 filed April 1, 2025 and titled RUNTIME ANALYSIS AND BALANCED SHUTDOWN FOR LIQUID COOLING SYSTEM. Said U.S. Provisional Patent Application 63/781,750.

### TECHNICAL FIELD

The present disclosure is directed to systems for providing thermal management within enclosed spaces where a controlled environment is required.

### BACKGROUND

In a two-stage cooling system for a data center or like environment, coolant distribution units (CDU) may be powered by various uninterruptible power supplies (UPS) or may rely on automatic transfer switches (ATS) connected to auxiliary or backup power sources. However, conventional CDU control logics do not provide for graceful shutdown of downstream information technology (IT) workloads or devices in the event of a loss of utility power, thus potentially endangering both the downstream workloads and downstream hardware.

### SUMMARY

In a first aspect, a liquid cooling system providing thermal management for servers, switches, and/or downstream information technology (IT) devices is disclosed. For example, the liquid cooling system may include one or more coolant distribution units (CDU) for circulating a fluid coolant through one or more downstream IT devices via a fluid network, the downstream IT devices served by a primary power source including one or more power distribution units (PDU). Further, the CDUs may be powered by an uninterruptible power supply (UPS). In examples, the CDUs, PDU, and downstream IT devices may be connected to a controller device configured for monitoring the remaining runtime of the UPS devices. For example, when a loss of the primary power source is detected, the controller may calculate a remaining system runtime for the CDUs based on the current UPS runtime. In examples, the controller may initiate a shutdown protocol for the downstream IT devices when the remaining system runtime is at least a threshold level, verify completion of the shutdown protocol, and transition the CDUs to an idle state once the shutdown protocol is completed.

In some examples, when the remaining system runtime is below a threshold level, the controller may generate a runtime alert and transition the CDUs to an idle state.

In some examples, the shutdown protocol may include determining workload save points for the downstream IT devices.

In some examples, the shutdown protocol may include powering down the PDUs.

In some examples, when completion of the shutdown protocol is verified, the controller may flush the fluid network via the CDUs according to a predetermined coolant temperature.

In some examples, the UPS may include a server-based UPS.

In some examples, the UPS may include a rack-based UPS associated with a particular device rack or a shelf thereof.

In some examples, the UPS may include an automatic transfer switch (ATS) capable of transferring the CDUs to a backup or auxiliary power source.

In some examples, the controller device may monitor UPS or battery runtimes at predetermined time intervals.

In a further aspect, a method for shutdown of a liquid cooling system providing thermal management for one or more servers, switches, or other like downstream information technology (IT) devices is disclosed. In examples, the method may include providing coolant distribution units (CDU) for circulating a fluid coolant through the downstream IT devices via a fluid network. For example, the downstream IT devices may be powered by a primary power source (e.g., utility grid) via power distribution units (PDU), and the CDUs may be powered by uninterruptible power supply (UPS) devices or systems. The method may include monitoring remaining battery runtimes associated with the UPS devices or systems. The method may include detecting a current or imminent loss of the primary power source. The method may include, when the primary power loss is detected, calculating a remaining system runtime associated with the CDUs based on the current remaining battery runtimes. The method may include, when the remaining system runtime is at or above a threshold level, initiating a shutdown protocol for the downstream IT devices. The method may include verifying completion of the shutdown protocol. The method may include, when completion of the shutdown protocol is verified, transitioning the CDUs to an idle runstate.

In some examples, the method may include, when the remaining system runtime is below the threshold level, generating a runtime alert. The method may further include transitioning the one or more CDUs to the idle runstate.

In some examples, the method may include flushing the fluid network via fluid coolant circulated by the CDUs according to a predetermined outlet temperature (e.g., of fluid coolant leaving the CDU).

In some examples, the method may include powering down the PDUs according to the shutdown protocol.

In some examples, the method may include determining workload save points for the downstream IT devices according to the shutdown protocol.

In some examples, the method may include monitoring a battery runtime of a server-based UPS device associated with a server or other downstream IT device.

In some examples, the method may include monitoring a battery runtime of a rack-based UPS device associated with a device rack or shelf thereof.

In some examples, the method may include transferring the CDUs to a backup or auxiliary power supply via an automatic transfer switch (ATS).

In some examples, the method may include monitoring the remaining UPS battery runtime/s at a predetermined time interval.

This Summary is provided solely as an introduction to subject matter that is fully described in the Detailed Description and Drawings. The Summary should not be considered to describe essential features nor be used to determine the scope of the Claims. Moreover, it is to be understood that both the foregoing Summary and the following Detailed Description are example and explanatory only and are not necessarily restrictive of the subject matter claimed.

### BRIEF DESCRIPTION OF THE DRAWINGS

The detailed description is described with reference to the accompanying figures. The use of the same reference numbers in different instances in the description and the figures may indicate similar or identical items. Various examples ("examples") of the present disclosure are disclosed in the following detailed description and the accompanying drawings. The drawings are not necessarily to scale. In general, operations of disclosed processes may be performed in an arbitrary order, unless otherwise provided in the claims. In the drawings:
FIG. 1 is a diagrammatic illustration of a pumped two-phase cooling system configured for runtime analysis and balanced shutdown according to examples of the inventive concepts disclosed herein; and
FIGS. 2A and 2B are process flow diagrams illustrating a method for runtime analysis and balanced shutdown of a cooling system according to examples of the inventive concepts disclosed herein.

### DETAILED DESCRIPTION

Before explaining one or more examples of the disclosure in detail, it is to be understood that the examples are not limited in their application to the details of construction and the arrangement of the components or steps or methodologies set forth in the following description or illustrated in the drawings. In the following detailed description of examples, numerous specific details may be set forth in order to provide a more thorough understanding of the disclosure. However, it will be apparent to one of ordinary skill in the art having the benefit of the instant disclosure that the examples disclosed herein may be practiced without some of these specific details. In other instances, well-known features may not be described in detail to avoid unnecessarily complicating the instant disclosure.

As used herein a letter following a reference numeral is intended to reference an example of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of examples disclosed herein. This is done merely for convenience and "a" and "an" are intended to include "one" or "at least one," and the singular also includes the plural unless it is obvious that it is meant otherwise.

Finally, as used herein any reference to "one example" or "some examples" means that a particular element, feature, structure, or characteristic described in connection with the example is included in at least one example disclosed herein. The appearances of the phrase "in some examples" in various places in the specification are not necessarily all referring to the same example, and examples may include one or more of the features expressly described or inherently present herein, or any combination or sub-combination of two or more such features, along with any other features which may not necessarily be expressly described or inherently present in the instant disclosure.

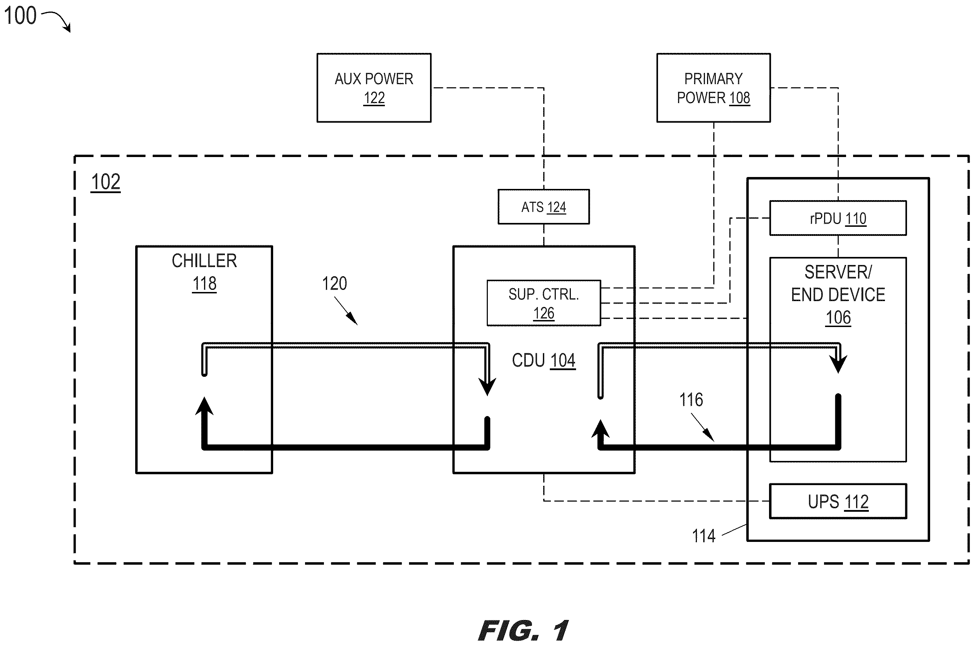

### FIG. 1 - SYSTEM GENERALLY

Broadly speaking, examples of the inventive concepts disclosed herein are directed to a system and method for runtime analysis and shutdown control of a cooling system for a data center environment. For example, the system monitors primary and backup power supplies and, in the event of an imminent loss of utility power, determines the system runtime available to the cooling system via backup uninterruptible power supplies (UPS). If sufficient runtime remains available prior to the loss of power, the system initiates a graceful shutdown of downstream IT devices, preserving the IT hardware as well as any workloads currently executing thereon. When the shutdown is complete, the cooling system transitions to an idle state for more efficient restart once power is restored.

Referring now to FIG. 1, a cooling system 100 for a data center environment 102 or like climate-controlled environment is shown. The cooling system 100 may include coolant distribution units 104 (CDU; also coolant delivery units), end devices 106, primary power supplies 108 (also utility power supplies), power distribution units 110 (PDU), and uninterruptible power supplies 112 (UPS).

In examples, the end devices 106 may include servers, switches, and/or any appropriate downstream information technology (IT) devices incorporating processors and/or chips drawing operating power from a primary power supply 108. For example, end devices 106 may be plugged into, or otherwise connected to, PDUs 110 and may be provided with operating power via the PDUs. End devices 106 incorporated into racks 114 or shelves within the data center environment 102 may be plugged into shelf-level or rack-level PDUs (rack PDUs, or rPDUs).

In examples, processors or chips within the end devices 106 may, in the processing of various workloads, convert their operating power almost totally into thermal energy. This heat must be removed from the data center environment 102, or the operation of the end devices 106 may be adversely affected; for example, throttling or shutdown of processors and/or end devices may be necessary, delaying completion of assigned workloads.

In examples, the cooling system 100 may generally transfer heat from the end devices to a medium via which the heat can be removed from the data center environment 102. For example, the CDUs 104 may circulate a fluid coolant or fluid refrigerant through the end devices 106 via a fluid network 116. The fluid coolant may be pumped by the CDUs 104 at a predetermined flow rate and/or outlet temperature based on cooling capacity requirements associated with the end devices 106 and data center environment 102, e.g., thermal energy generated by the end devices, dimensions of the data center environment, individual and/or group cooling capacity of the CDUs 104.

In some examples, the cooling system 100 may be a pumped two-phase cooling system wherein the CDUs 104 and fluid network 116 (e.g., a secondary fluid network) comprise a second phase and wherein a chiller device 118 and primary fluid network 120 comprise a first phase. For example, the secondary fluid network 116 circulating through the end devices 106 may transfer heat from the end devices to the fluid coolant. The transferred heat may be transferred again from the secondary fluid network 116 to the primary fluid network 120 via heat exchangers within the CDUs 104. The primary fluid network 120 may return the transferred heat to the chiller device 118, which removes the heat from the end devices 106, e.g., via fans directing the heat into the outside air external to the data center environment 102.

In some examples (not shown), the end devices 106 may be an air-cooled system wherein the CDUs 104 circulate a chilled fluid coolant via the fluid network 116 and fans direct an airstream over the fluid network to circulate chilled air throughout the data center environment 102. For example, the circulating airstream may absorb heat from the ambient air within the data center environment 102 and remove the absorbed air from the cooling system 100 via, e.g., return air ducts and a chiller device 118 directing heated return air externally to the data center environment 102.

In examples, the CDUs 104 may draw operating power from the primary power supplies 108 and/or from one or more UPS 112. For example, the CDUs 104 may draw power from the primary power supplies 108 but may also maintain a battery-based rack-level UPS 112 (rUPS) or server-based UPS as a backup or emergency power supply. Similarly, the CDUs 104 may be connected to auxiliary power 122 via an automatic transfer switch 124 (ATS).

In examples, the cooling system 100 may include a supervisory controller 126. For example, control processors within a CDU 104, or within an external processing device connected to the CDUs and/or chiller device 118, may be programmed or otherwise configured for proactive power and runtime monitoring. In examples, the supervisory controller 126 may monitor the primary power supplies 108 to detect an imminent loss of utility power therefrom.

Further, the supervisory controller 126 may monitor the uninterruptible power supplies 112 to determine potential runtime available to the CDUs 104 in the event of a loss of utility power. In examples, the supervisory controller 126 may determine at predetermined intervals the battery power available via the uninterruptible power supplies 112, e.g., every minute, every 10 minutes, every 30 minutes, every hour. Similarly, the supervisory controller 126 may monitor multiple uninterruptible power supplies 112 and track a remaining system runtime available via each UPS. In examples, the supervisory controller 126 may include memory or other like data storage for maintaining the most recently determined remaining system runtime/s.

In examples, when an imminent loss of utility power via the primary power supplies 108 is detected, the supervisory controller 126 may determine any available remaining system runtimes in response, or refer to the most recently determined remaining system runtimes. If, for example, the remaining system runtime (or a particular system runtime, if multiple UPS 112 and/or auxiliary power sources are available) is at least a threshold amount, the supervisory controller 126 may initiate a shutdown protocol for downstream end devices 106. Alternatively, if the remaining system runtime is less than the threshold amount (e.g., if insufficient system runtime remains to initiate the shutdown protocol), the supervisory controller 126 may generate an alert and immediately transition the CDUs 104 to an idle runstate as described below.

In examples, the shutdown protocol initiated by the supervisory controller 126 may provide for a graceful shutdown of the end devices 106 and any workloads and/or processes currently executing thereon. For example, the shutdown protocol may provide for the determination of safe workload save points so that IT workloads and/or processes may efficiently be restarted when utility power is restored. In some examples, the shutdown protocol may include powering down any power distribution units 110 from which the end devices 106 are drawing operating power. In some examples, the shutdown protocol may include transferring one or more end devices 106 to backup or auxiliary power systems 122.

In examples, the supervisory controller 126 may verify that the shutdown protocol has been completed. When completion has been verified, for example, the supervisory controller 126 may transition the CDUs 104 into an idle runstate (from which the CDUs may be reactivated once utility power is restored. In some examples, transitioning the CDUs 104 to the idle runstate may include flushing the fluid network 116 to ramp down its temperature. For example, the CDUs 104 may cycle a fluid coolant through the fluid network 116 at a predetermined outlet temperature to prevent stranding of any transferred thermal load proximate to the end devices 106.

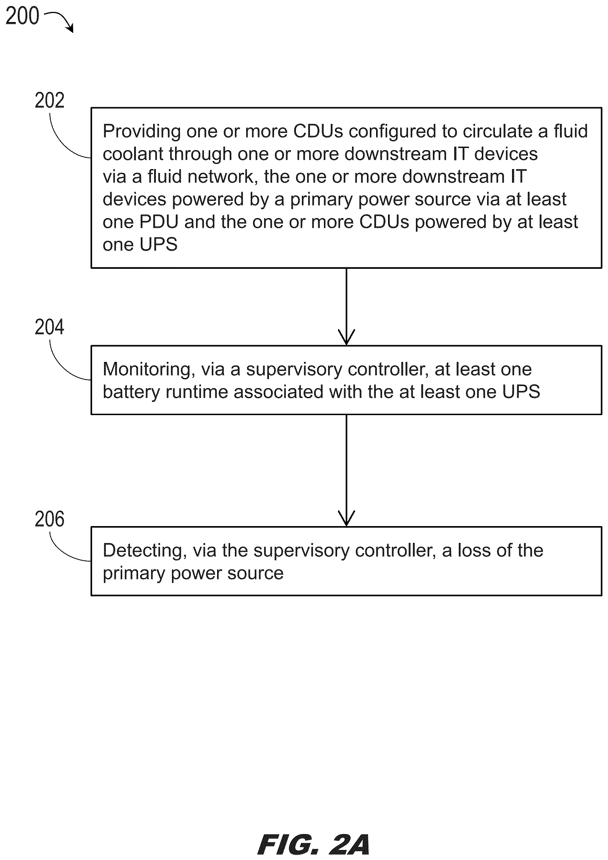

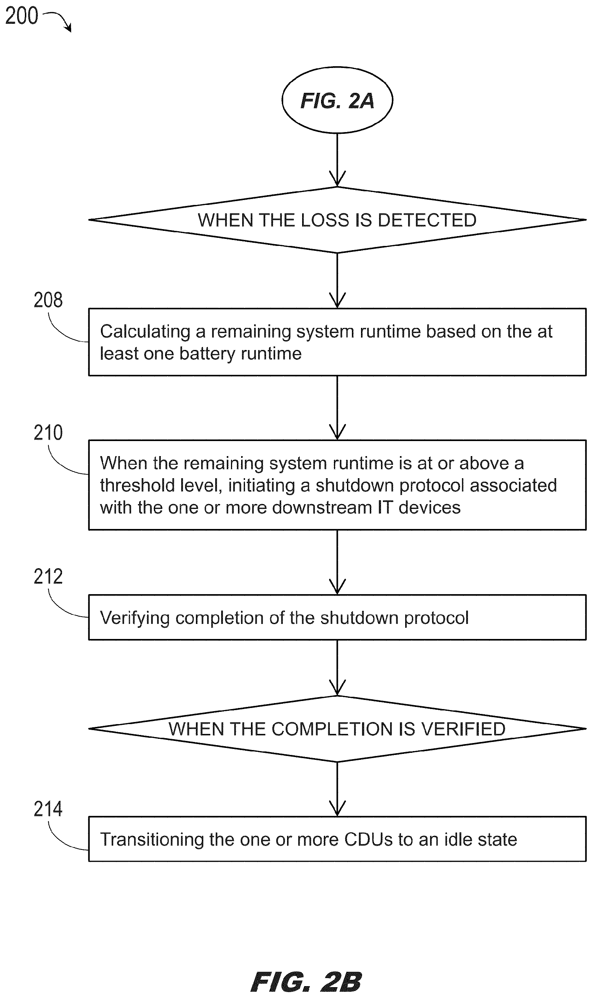

### FIGS. 2A and 2B - METHOD

Referring now to FIG. 2A, the method 200 may be implemented by the cooling system 100 and may include the following steps.

At a step 202, the cooling system provides coolant distribution units (CDU) to circulate a fluid coolant through one or more downstream IT devices (end devices) via a fluid network. For example, the downstream IT devices are powered by a utility power source via power distribution units (PDU) into which the IT devices are plugged or connected, and the CDUs may likewise draw power from the utility source but may maintain backup or emergency power via uninterruptible power supplies (UPS). For example, UPS may include rack-based or server-based battery-powered units, or access to an auxiliary power source via an automatic transfer switch (ATS).

At a step 204, a supervisory controller of the cooling system monitors available remaining system runtimes available via various battery-powered UPS or backup power sources, e.g., in the event of a loss of primary or utility power.

At a step 206, the supervisory controller detects an imminent or current loss of utility power.

Referring also to FIG. 2B, at a step 208, when a loss of utility power is detected, the supervisory controller determines any available remaining system runtimes. In some examples, the controller refers to the most recently determined remaining system runtimes. In some examples, when the remaining system runtime/s are under a threshold level (e.g., required for initiating a shutdown protocol), the supervisory controller generates a runtime alert and immediately transitions the CDUs to an idle runstate.

At a step 210, when the remaining system runtime (e.g., via at least one UPS or auxiliary power source) is above the threshold level, the supervisory controller initiates a shutdown protocol for the downstream IT devices. In some examples, the shutdown protocol includes determining workload save points for any IT workloads or processes currently running on the downstream IT devices. In some examples, the shutdown includes powering down any PDUs from which the downstream IT devices are drawing utility power. In some examples, the shutdown protocol includes transferring one or more downstream IT devices to backup or auxiliary power units.

At a step 212, the supervisory controller verifies completion of the shutdown protocol.

At a step 214, when completion of the shutdown protocol has been verified, the supervisory controller transitions the CDUs to an idle runstate. In some examples, the transition includes cycling fluid coolant through the fluid network at a predetermined outlet temperature to flush any remaining thermal load from the fluid network and away from the downstream IT devices.

### CONCLUSION

It is contemplated that examples of the inventive concepts disclosed herein may have numerous advantages. For example, as noted above, runtime analysis provides for a proactive response to loss of utility power by allowing for a graceful shutdown of downstream IT devices and CDUs without stranding thermal loads in the proximate fluid network, protecting any active IT workloads as well as the associated hardware.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary. Those skilled in the art will recognize that optical aspects of implementations will typically employ optically-oriented hardware, software, and/or firmware.

The foregoing detailed description has set forth various examples of the devices and/or processes via the use of block diagrams, flowcharts, and/or examples. Insofar as such block diagrams, flowcharts, and/or examples contain one or more functions and/or operations, it will be understood by those within the art that each function and/or operation within such block diagrams, flowcharts, or examples can be implemented, individually and/or collectively, by a wide range of hardware, software, firmware, or virtually any combination thereof. In one example, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the examples disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this disclosure. In addition, those skilled in the art will appreciate that the mechanisms of the subject matter described herein are capable of being distributed as a program product in a variety of forms, and that an illustrative example of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.
Further examples are set out in the clauses below:
1. A liquid cooling system, the system comprising:
   one or more coolant distribution units (CDU) configured for circulating a fluid coolant via a fluid network through one or more downstream information technology (IT) devices powered by a primary power source via at least one power distribution unit (PDU),
   wherein the one or more CDUs are connected to at least one uninterruptible power supply (UPS) and capable of drawing operating power therefrom;
      and
   a supervisory controller operatively coupled to the one or more CDUs, the at least one PDU, and to the one or more downstream IT devices, the supervisory controller including at least one control processor configured to:
      monitor at least one battery runtime associated with the at least one UPS;
         and
      when a loss of the primary power source is detected:
         based on the at least one battery runtime, calculate a remaining system runtime corresponding to the one or more CDUs;
         when the remaining system runtime is at or above a threshold level, initiate a shutdown protocol associated with the one or more downstream IT devices;
         verify completion of the shutdown protocol;
            and
         transition the one or more CDUs to an idle state.
2. The system of Clause 1, wherein the at least one control processor is configured to:
   when the calculated system runtime is below the threshold level:
   generate a runtime alert;
      and
   transition the one or more CDUs to the idle state.
3. The system of any one of the preceding Clauses, wherein the shutdown protocol includes determining at least one workload save point associated with the one or more downstream IT devices.
4. The system of any one of the preceding Clauses, wherein the shutdown protocol includes powering down the at least one PDU.
5. The system of any one of the preceding Clauses, wherein, when completion of the shutdown protocol is verified, the supervisory controller is configured to direct the one or more CDUs to flush the fluid network via the fluid coolant, according to a predetermined coolant temperature.
6. The system of any one of the preceding Clauses, wherein the at least one UPS includes at least one server-based UPS associated with an IT device of the one or more downstream IT devices.
7. The system of any one of the preceding Clauses, wherein the at least one UPS includes at least one rack-based UPS associated with at least one of a device shelf or a device rack.
8. The system of any one of the preceding Clauses, wherein the at least one UPS includes at least one automatic transfer switch (ATS) associated with an auxiliary power source, the ATS capable of transferring the one or more CDUs to the auxiliary power source.
9. The system of any one of the preceding Clauses, wherein monitoring the at least one battery runtime includes determining the at least one battery runtime at a predetermined time interval.
10. A method for shutdown control of a liquid cooling system, the method comprising:
   providing one or more coolant distribution units (CDU) configured to circulate a fluid coolant through one or more downstream information technology (IT) devices via a fluid network, the one or more downstream IT devices powered by a primary power source via at least one power distribution unit (PDU) and the one or more CDUs powered by at least one uninterruptible power supply (UPS);
   monitoring, via a supervisory controller, at least one battery runtime associated with the at least one UPS;
   detecting, via the supervisory controller, a loss of the primary power source;
      and
   when the loss is detected, via the supervisory controller:
      calculating a remaining system runtime based on the at least one battery runtime;
      when the remaining system runtime is at or above a threshold level, initiating a shutdown protocol associated with the one or more downstream IT devices;
      verifying completion of the shutdown protocol;
         and
      when the completion is verified, transitioning the one or more CDUs to an idle state.
11. The method of Clause 10, wherein the method further comprises:
   when the remaining system runtime is below the threshold level:
   generating a runtime alert; and
   transitioning the one or more CDUs to the idle state.
12. The method of Clause 10 or 11, wherein transitioning the one or more CDUs to an idle state includes:
   flushing the fluid network via the fluid coolant according to a predetermined outlet temperature.
13. The method of any one of the Clauses 10-12, wherein initiating a shutdown protocol associated with the one or more downstream IT devices includes:
   powering down the at least one PDU.
14. The method of any one of the Clauses 10-13, wherein initiating a shutdown protocol associated with the one or more downstream IT devices includes:
   determining at least one workload save point associated with the one or more downstream IT devices.
15. The method of any one of the Clauses 10-14, wherein monitoring, via a supervisory controller, at least one battery runtime associated with the at least one UPS includes:
   monitoring at least one battery runtime associated with a server-based UPS associated with an IT device of the one or more downstream IT devices.
16. The method of any one of the Clauses 10-15, wherein monitoring, via a supervisory controller, at least one battery runtime associated with the at least one UPS includes:
   monitoring at least one battery runtime associated with a rack-based UPS associated with at least one of a device shelf or a device rack.
17. The method of any one of the Clauses 10-16, wherein initiating a shutdown protocol associated with the one or more downstream IT devices includes:
   transferring the one or more CDUs to an auxiliary power supply via an automatic transfer switch (ATS).
18. The method of any one of the Clauses 10-17, wherein:
   monitoring, via a supervisory controller, at least one battery runtime associated with the at least one UPS includes:
   monitoring the at least one battery runtime according to a predetermined time interval.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the scope of the subject matter described herein.

## Claims

1. A liquid cooling system, the system comprising:
one or more coolant distribution units (CDU) configured for circulating a fluid coolant via a fluid network through one or more downstream information technology (IT) devices powered by a primary power source via at least one power distribution unit (PDU),
wherein the one or more CDUs are connected to at least one uninterruptible power supply (UPS) and capable of drawing operating power therefrom;
and
a supervisory controller operatively coupled to the one or more CDUs, the at least one PDU, and to the one or more downstream IT devices, the supervisory controller including at least one control processor configured to:
monitor at least one battery runtime associated with the at least one UPS;
and
when a loss of the primary power source is detected:
based on the at least one battery runtime, calculate a remaining system runtime corresponding to the one or more CDUs;
when the remaining system runtime is at or above a threshold level, initiate a shutdown protocol associated with the one or more downstream IT devices;
verify completion of the shutdown protocol;
and
transition the one or more CDUs to an idle state.

2. The system of Claim 1, wherein the at least one control processor is configured to:
when the calculated system runtime is below the threshold level:
generate a runtime alert;
and
transition the one or more CDUs to the idle state.

3. The system of any one of the preceding Claims, wherein the shutdown protocol includes determining at least one workload save point associated with the one or more downstream IT devices.

4. The system of any one of the preceding Claims, wherein the shutdown protocol includes powering down the at least one PDU.

5. The system of any one of the preceding Claims, wherein, when completion of the shutdown protocol is verified, the supervisory controller is configured to direct the one or more CDUs to flush the fluid network via the fluid coolant, according to a predetermined coolant temperature.

6. The system of any one of the preceding Claims, wherein the at least one UPS includes at least one server-based UPS associated with an IT device of the one or more downstream IT devices.

7. The system of any one of the preceding Claims, wherein the at least one UPS includes at least one rack-based UPS associated with at least one of a device shelf or a device rack.

8. The system of any one of the preceding Claims, wherein the at least one UPS includes at least one automatic transfer switch (ATS) associated with an auxiliary power source, the ATS capable of transferring the one or more CDUs to the auxiliary power source.

9. The system of any one of the preceding Claims, wherein monitoring the at least one battery runtime includes determining the at least one battery runtime at a predetermined time interval.

10. A method for shutdown control of a liquid cooling system, the method comprising:
providing one or more coolant distribution units (CDU) configured to circulate a fluid coolant through one or more downstream information technology (IT) devices via a fluid network, the one or more downstream IT devices powered by a primary power source via at least one power distribution unit (PDU) and the one or more CDUs powered by at least one uninterruptible power supply (UPS);
monitoring, via a supervisory controller, at least one battery runtime associated with the at least one UPS;
detecting, via the supervisory controller, a loss of the primary power source;
and
when the loss is detected, via the supervisory controller:
calculating a remaining system runtime based on the at least one battery runtime;
when the remaining system runtime is at or above a threshold level, initiating a shutdown protocol associated with the one or more downstream IT devices;
verifying completion of the shutdown protocol;
and
when the completion is verified, transitioning the one or more CDUs to an idle state.

11. The method of Claim 10, wherein the method further comprises:
when the remaining system runtime is below the threshold level:
generating a runtime alert;
and
transitioning the one or more CDUs to the idle state.

12. The method of Claim 10 or 11, wherein transitioning the one or more CDUs to an idle state includes:
flushing the fluid network via the fluid coolant according to a predetermined outlet temperature.

13. The method of any one of Claims 10-12, wherein initiating a shutdown protocol associated with the one or more downstream IT devices includes:
powering down the at least one PDU.

14. The method of any one of Claims 10-12, wherein initiating a shutdown protocol associated with the one or more downstream IT devices includes:
determining at least one workload save point associated with the one or more downstream IT devices.

15. The method of any one of Claims 10-12, wherein monitoring, via a supervisory controller, at least one battery runtime associated with the at least one UPS includes:
monitoring at least one battery runtime associated with a server-based UPS associated with an IT device of the one or more downstream IT devices; or optionally
wherein monitoring, via a supervisory controller, at least one battery runtime associated with the at least one UPS includes:
monitoring at least one battery runtime associated with a rack-based UPS associated with at least one of a device shelf or a device rack; or optionally
wherein initiating a shutdown protocol associated with the one or more downstream IT devices includes:
transferring the one or more CDUs to an auxiliary power supply via an automatic transfer switch (ATS); or optionally
wherein:
monitoring, via a supervisory controller, at least one battery runtime associated with the at least one UPS includes:
monitoring the at least one battery runtime according to a predetermined time interval.
